# EUROPÄISCHE PATENTSCHRIFT

(11) **EP 0 853 685 B1**
(45) Veröffentlichungstag und Bekanntmachung des Hinweises auf die Patenterteilung: **07.07.1999**
(21) Anmeldenummer: 96943863.9
(22) Anmeldetag: 02.10.1996
(51) Int. Cl.: C23C 14/20, C23C 14/08, G02B 5/28, B32B 17/10

(54) **TRANSPARENTE WÄRMESCHUTZFOLIE UND VERFAHREN ZU DEREN HERSTELLUNG**
TRANSPARENT HEAT PROTECTION FOIL AND PROCESS FOR PRODUCING THE SAME
FEUILLE TRANSPARENTE CALORIFUGE ET SON PROCEDE DE PRODUCTION

(30) Priorität: 06.10.1995 DE 19537263
(43) Veröffentlichungstag der Anmeldung: 22.07.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: KIRCHHOFF, Volker, Dipl.-Phys., D-01324 Dresden (DE); SCHILLER, Siegfried, Dr., D-01324 Dresden (DE); NEUMANN, Manfred, Dr., D-01217 Dresden (DE); MILDE, Falk, Dipl.-Phys., D-01109 Dresden (DE)
(86) Internationale Anmeldenummer: DE9601905
(87) Internationale Veröffentlichungsnummer: WO9713003

(56) Entgegenhaltungen:
- EP-A- 0 279 550
- DE-A- 4 211 363
- US-A- 4 861 680

## Beschreibung

Die Erfindung betrifft eine transparente, abriebfeste Wärmeschutzfolie für Außenanwendung, insbesondere zum Aufbringen auf die Außenseite von Fensterflächen von Gebäuden und Fahrzeugen und ein Verfahren zu deren Herstellung. Das Aufkleben derartiger Wärmeschutzfolien hat gegenüber der direkten Vakuumbeschichtung der Fensterflächen den Vorteil, daß auch bereits installierte Fenster nachträglich mit Wärmeschutzfolien ausgerüstet werden können. Außerdem ist das Auftragen von Wärmeschutzschichten auf Kunststoffolien von Rolle zu Rolle mit höherer Produktivität und daher mit geringeren Kosten möglich als das Beschichten einzelner Glasscheiben.

Die Beschichtung von Fensterflächen mit transparenten Wärmeschutzschichten gewinnt steigende Bedeutung im Zusammenhang mit der Einsparung von Klimatisierungskosten im Sommer und der Einsparung von Heizkosten im Winter.

Es sind Wärmeschutzfolien zur Verringerung der Sonneneinstrahlung zum Aufkleben auf Fensterflächen von Gebäuden und Fahrzeugen bekannt. In den meisten Fällen handelt es sich dabei um Polyesterfolien, die im Vakuum durch Bedampfen oder Sputtern mit dünnen Metallschichten versehen wurden. Diese Metallschichten haben eine annähernd wellenlängenunabhängige Reflexion, so daß sie neben der Wärmeeinstrahlung in etwa gleichem Ausmaß auch die Lichtdurchlässigkeit verringern. Außerdem halten diese Wärmeschutzfolien mechanischen Beanspruchungen, wie sie bei Fahrzeugscheiben - insbesondere Windschutzscheiben - auftreten, nicht stand.

Es ist auch bekannt, durch Einsatz von Wechselschichtsystemen anstelle einfacher Metallschichten die Lichtdurchlässigkeit von Wärmeschutzfolien bei gleichzeitig hoher Wärmestrahlenreflexion zu erhöhen (DE 40 20 696). Dabei handelt es sich im allgemeinen um Wechselschichten, das sind einander abwechselnde Schichten aus Metall und Nichtmetall, wobei als Metall meist Silber verwendet wird. Wegen der hohen Korrosionsempfindlichkeit der Silberschichten und der Kratzempfindlichkeit der sehr dünnen Wechselschichtsysteme müssen diese Wärmeschutzfolien mit der Schichtseite gegen das Glas geklebt werden. Damit ist der Nachteil verbunden, daß die zu reflektierende Wärmestrahlung zweimal die Kunststoffolie durchdringen muß und dadurch einen Teil der Wärme absorbiert. Diese Anordnung hat weiterhin den Nachteil, daß die relativ weiche Kunststoffolie nach außen zeigt und beim üblichen Reinigen der Fenster relativ schnell zerkratzt wird. Außerdem können derartige Folien wegen der mangelhaften Witterungs- und UV-beständigkeit der Kunststoffolien nicht auf die Außenseite der Fensterscheiben aufgeklebt werden. Das hat beim Einsatz als Sonnenschutzfolie wiederum zur Folge, daß die Sonnenstrahlung zweimal die äußere Glasscheibe passieren muß und dadurch die Scheibe erwärmt. Das verringert die Effektivität der Wärmestrahlenreflexion und kann bei lokal unterschiedlicher Erwärmung sogar zum Zerspringen der Scheibe führen.

Es ist weiterhin bekannt, mit Hilfe sogenannter Hard-coats, das sind durch Wärme-, Plasma- oder Koronabehandlung gehärtete organische Schichten, die Abriebfestigkeit von Wärmeschutzfolien zu erhöhen. Diese Schichten können sowohl auf das Wechselschichtsystem als auch auf die Rückseite der Kunststoffolie aufgetragen werden (US 5,306,547; US 4,799,745). Damit ist zumindest eine gewisse Kratzfestigkeit für die Innenanwendung gewährleistet. Für die Außenanwendung ist diese Lösung wegen der ungenügenden Witterungs- und UV-Beständigkeit und der doch begrenzten Abriebfestigkeit der Hard-coats ebenfalls ungeeignet.

Es ist auch bekannt, Wärmeschutzschichten auf Glasscheiben mit anorganischen Abriebschutzschichten zu versehen, die eine bessere Witterungsbeständigkeit als organische Hard-coats aufweist (US 5,085,926; JP-A 63-206333). Diese Abriebschutzschichten ergeben jedoch bei Anwendung auf flexiblen Wärmeschutzfolien völlig unzureichende Abriebfestigkeiten, insbesondere wenn es sich um relativ harte Beanspruchungen wie bei Windschutzscheiben von Fahrzeugen handelt. Das ist wahrscheinlich durch die im Vergleich zum Glas wesentlich höhere Nachgiebigkeit der Kunststoffolien bedingt, die in Mikrobereichen zur Verformung und damit zur Beschädigung der Abriebschutzschichten führt.

Der Erfindung liegt die Aufgabe zugrunde, eine transparente Wärmeschutzfolie mit einem abriebfesten und witterungsbeständigen, selektiv reflektierenden Schichtsystem für die Außenanwendung zu schaffen. Die Wärmeschutzfolie soll vorzugsweise zum Aufkleben auf Fensterflächen von Gebäuden oder Fahrzeugen geeignet sein, indem das wärmereflektierende Schichtsystem nach außen zeigt. Bei der dadurch bedingten hohen Abrieb- und Korrosionsbeanspruchung soll die Wärmeschutzfolie eine wesentlich höhere Lebensdauer als die bisher bekannten Wärmeschutzfolien aufweisen. Das Grundmaterial soll eine Kunststoffolie, vorzugsweise Polyester sein. Es ist weiterhin ein Verfahren zur Herstellung dieser Wärmeschutzfolien zu schaffen, das relativ geringe Herstellungskosten ermöglicht, um eine breite Anwendung zu gewährleisten. Zur Ausübung des Verfahrens sind weitgehend bekannte und hochproduktive Verfahren der Vakuumbeschichtungstechnik einzusetzen.

Die Aufgabe, eine Wärmeschutzfolie zu schaffen, wird nach dem Anspruch 1 gelöst. Das zur Herstellung erforderliche Verfahren wird nach Anspruch 13 gelöst. Vorteilhafte Ausgestaltungen der Wärmeschutzfolie und des Herstellungsverfahrens sind in den Ansprüchen 2 bis 12 bzw. 14 bis 16 beschrieben.

Die hohe Korrosionsbeständigkeit des Wechselschichtsystems wird zunächst erreicht durch gezielte Auswahl der Schichtmaterialien aus der Vielzahl der bereits bekannten Materialien. Besonders korrosionsbeständig sind Oxid-, Nitrid- oder Oxinitridschichten. Aber auch Metallschichten aus Ti, Zr, Cr und Ni weisen eine hohe Korrosionsbeständigkeit auf. Die Anordnung der genannten Schichten im Wechselschichtsystem erfolgt in an sich bekannter Weise, wobei sich leiffähige Metall- oder Nitridschichten mit reflexionsmindernden, meist dielektrischen Oxid- oder Oxinitridschichten abwechseln.

Die hohe Korrosionsbeständigkeit der Wärmeschutzfolie insgesamt wird durch Kombination dieses bereits in hohem Maße korrosionsbeständigen Wechselschichtsystems mit einer oxidischen Abriebschutzschicht erreicht, die infolge ihrer Dicke, ihrer homogenen, amorphen Struktur sowie ihrer hohen Packungsdichte besondere korrosionsschützende Eigenschaften aufweist.

Ein wesentlicher Grund für das Erreichen der hohen Abriebfestigkeit der erfindungsgemäßen Wärmeschutzfolie ist in der Dicke und der gleichzeitig hohen Härte dieser Schicht zu sehen. Bei einer Dicke der Abriebschutzschicht von mindestens 1 µm, vorzugsweise 2 bis 5 µm, und einer Mikrohärte von mindestens 4 GPa, vorzugsweise 5 GPa bis 10 GPa, sind bisher nicht erreichte Korrosions-, Witterungs- und UV-Beständigkeiten zu erreichen.

Überraschenderweise wurde gefunden, daß die große Dicke im Zusammenwirken mit der hohen Packungsdichte und Mikrohärte der Schicht gewährleistet, daß trotz Verwendung der relativ weichen Kunststoffolien Abriebfestigkeiten erreicht werden, wie sie bisher nur bei Wärmeschutzschichten auf Glas erzielt wurden. Bei geringeren Dicken oder geringeren Mikrohärten können Staubkörner, insbesondere im Zusammenwirken mit Scheibenwischern an Fahrzeugen, entweder zu Mikrodeformationen und Mikrorissen oder zum Anritzen der Abriebschutzschicht führen. Die Zerstörung der Abriebschutzschicht geht nach Auftreten dieser Defekte um so schneller vonstatten, je geringer die Haftfestigkeit der Abriebschutzschicht zum darunter liegenden Wechselschichtsystem ist.

Die hohe Korrosionsbeständigkeit und Abriebfestigkeit der erfindungsgemäßen Wärmeschutzfolie ist außer von der Auswahl geeigneter Materialien entscheidend vom Herstellungsverfahren abhängig.

Erfindungsgemäß wird die hohe Korrosionsbeständigkeit des Wechselschichtsystems nicht nur durch die gezielte Auswahl besonders korrosionsbeständiger Schichtmaterialien, sondern vor allem durch den Einsatz spezieller Beschichtungsverfahren und die dazu verwendeten Anlagen erreicht. So ist dazu ganz besonders zum Aufbringen der einzelnen Schichten das Pulsmagnetronsputtern geeignet und erzielt überraschenderweise die hervorragenden Eigenschaften des Schichtsystems. Dieses erst seit kurzem bekannte Sputterverfahren hat im Vergleich zu anderen bekannten Sputterverfahren den Vorteil, daß besonders defektfreie und daher korrosionsstabile Schichten abgeschieden werden. Durch den impulsweise erfolgenden Sputterprozeß werden Mikroentladungen auf der Targetoberfläche und dadurch bedingte Defekte vermieden. Besonders für das Abscheiden elektrisch isolierender oder schlecht leitender Oxide, Oxinitride oder Nitride ist das bipolare Pulsmagnetronsputtern unter Verwendung sogenannter Dual-Magnetrons vorteilhaft. Hierbei wird nicht nur eine hohe Defektfreiheit, sondern durch das Vermeiden der Anodenverschmutzung auch eine hohe Langzeitstabilität des Beschichtungsprozesses erzielt. Das gestattet die Einhaltung sehr enger Toleranzen in den Schichteigenschaften, was sowohl für eine optimale Wärmestrahlenreflexion als auch für eine reproduzierbare Korrosionsbeständigkeit von Bedeutung ist. Darüber hinaus ermöglicht das bipolare Pulsmagnetronsputtern mit Dual-Magnetrons, vor allem in Verbindung mit der Plasma-Emissions-Monitorierung, besonders hohe Beschichtungsraten, die wiederum eine kostengünstige Herstellung der erfindungsgemäßen Wärmeschutzfolie gestatten.

Die hohe Abriebfestigkeit der Abriebschutzschicht in Verbindung mit einem hohen Korrosionsschutz für das darunterliegende Wechselschichtsystem wird erfindungsgemäß nicht nur durch die Auswahl des Materials, sondern vor allem durch das Abscheiden mittels plasma- bzw. ionengestützter Hochratebedampfung erreicht. Damit wird sowohl eine hohe Beschichtungsrate für die kostengünstige Herstellung der Abriebschutzschicht als auch die erforderliche hohe Härte und eine homogene, amorphe Struktur mit hoher Packungsdichte erreicht. Darüber hinaus wurde eine hervorragende Haftfestigkeit der Abriebschutzschichten auf den verschiedenen Wechselschichtsystemen festgestellt. Vermutlich ist es neben der Härte vor allem die hohe Haftfestigkeit, die die außergewöhnliche Abriebfestigkeit des Schichtsystems bewirkt. Darüber hinaus ist auch die homogene, amorphe Struktur von Bedeutung, da sie bei der Abriebbeanspruchung, insbesondere in Verbindung mit Staub und Sandkörnern, keine Ansatzpunkte für die Schichtzerstörung bietet.

Auch für die zusätzliche Korrosionsschutzwirkung der Abriebschutzschicht ist eine homogene, amorphe Struktur mit hoher Packungsdichte von großer Bedeutung. Im Gegensatz zu lockeren, säulenförmig zerklüfteten Schichten geringer Pakkungsdichte, die bei dem üblichen Hochratbedampfen ohne Plasmaaktivierung entstehen, wird eine wesentliche Barrierewirkung gegenüber korrosiven Medien erreicht.

Erfindungsgemäß ist es zweckmäßig, zum Herstellen von Abriebschutzschichten aus den Oxiden von Zirkonium, Titan oder deren Legierungen die entsprechenden Metalle unter Zugabe von Sauerstoff mit dem Elektronenstrahl zu verdampfen und in der Bedampfungszone ein intensives Plasma mit Hilfe einer Hohlkatodenbogenentladung oder einer diffusen Bogenentladung zu erzeugen. Dagegen genügt für die Herstellung von Abriebschutzschichten aus Aluminiumoxid das plasmagestützte reaktive Verdampfen mit Hilfe einfacher Schiffchenverdampfer. Allerdings ist wie beim Elektronenstrahlverdampfen das Erzeugen hoher Plasmadichten in der Bedampfungszone erforderlich, wobei außer Hohlkatodenbogenentladungen auch gepulste Magnetronentladungen geeigent sind.

An einem Ausführungsbeispiel wird die Erfindung näher erläutert.

Die zugehörige Zeichnung zeigt einen Querschnitt durch eine Wärmeschutzfolie.

Auf die Kunststoffolie 1 aus hochtransparentem Polyester ist zunächst das Wechselschichtsystem 2 und darauf die Abriebschutzschicht 3 aufgebracht. Das Wechselschichtsystem 2 besteht aus einer unmittelbar auf die Kunststoffolie 1 aufgebrachten Titanoxidschicht 4 von 36 nm Dicke, einer darüber befindlichen Zirkoniumnitridschicht 5 von 12 nm Dicke, einer zweiten Titanoxidschicht 4 von 80 nm Dicke, einer zweiten Zirkoniumnitridschicht 5 von 18 nm Dicke und einer dritten Titanoxidschicht 4 von 36 nm Dicke. Die Abriebschutzschicht 3 besteht aus 4 µm dickem, homogen-amorphem Oxid ohne Stengelstruktur mit einer Mikrohärte von 6 GPa und einer Packungsdichte von 80 % einer massiven Aluminiumoxidkeramik.

Das Verfahren zur Herstellung der Wämeschutzfolie wird wie folgt ausgeführt: Die zu beschichtende Kunststoffolie wird in einer bekannten Beschichtungsanlage in einem Vakuumbehälter von einer Abwickelrolle zu einer Aufwickelrolle geführt. Der Vakuumbehälter ist in mehrere Kammern unterteilt, in denen sich jeweils eine Kühlwalze befindet, über die die Kunststoffolie geführt wird. Die Anzahl der Kammern richtet sich nach der Anzahl der aufzubringenden Schichten. Die Schichten werden mittels Dual-Magnetrons mit Titan- oder Zirkonium-Target bei dosiertem Sauerstoff- oder Stickstoffeinlaß, je nach der aufzubringenden Schicht bzw. des Wechselschichtsystems, aufgesputtert. Die Dual-Magnetrons werden mit einer Pulsfrequenz von 60 kHz betrieben.

Die Abriebschutzschicht aus Aluminiumoxid wird durch plasmagestützte reaktive Aluminiumverdampfung durch Verdampfen von Aluminium aus Schiffchenverdampfern aufgebracht. Die erforderliche Plasmaaktivierung erfolgt durch eine gepulste Magnetron-Plasmaquelle mit hoher Dampfdichte.

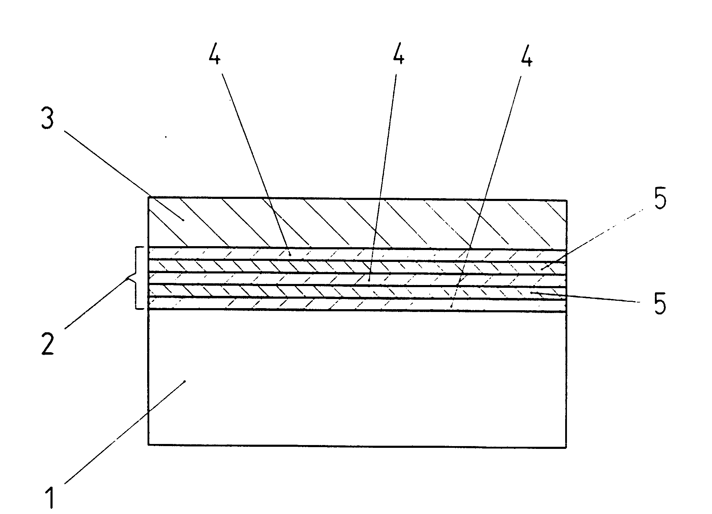

## Patentansprüche

1. Transparente Wärmeschutzfolie für Außenanwendung, bestehend aus einer Kunststoffolie und einem selektiv reflektierenden Wechselschichtsystem, auf dem eine Abriebschutzschicht aufgebracht ist, **dadurch gekennzeichnet**, daß das Wechselschichtsystem aus korrosionsbeständigen Metall-, Oxid-, Nitrid- und/oder Oxinitridschichten besteht und die Abriebschutzschicht aus einer mindestens 1 µm, vorzugsweise 2 bis 5 µm dicken, hochtransparenten und homogenen amorphen Oxidschicht mit hoher Pakkungsdichte und einer Mikrohärte von mindestens 4 GPa, vorzugsweise von 5 GPa bis 10 GPa, besteht.

2. Wärmeschutzfolie nach Anspruch 1, **dadurch gekennzeichnet**, daß die Kunststoffolie eine hochtransparente Polyesterfolie mit minimalem Füllstoffanteil und maximaler Oberflächenglätte ist.

3. Wärmeschutzfolie nach Anspruch 1 und 2, **dadurch gekennzeichnet**, daß das Wechselschichtsystem abwechselnd aus dielektrischen Oxidschichten und elektrisch leiffähigen Nitridschichten aufgebaut ist, und daß die erste auf der Kunststoffolie aufgebrachte Schicht und die letzte Schicht des Wechselschichtsystems eine dielektrische Oxidschicht ist.

4. Wärmeschutzfolie nach Anspruch 1 und 2, **dadurch gekennzeichnet**, daß das Wechselschichtsystem aus elektrisch leiffähigen Oxidschichten und elektrisch leiffähigen Nitridschichten aufgebaut ist, und daß die erste auf der Kunststoffolie aufgebrachte Schicht und die letzte Schicht des Wechselschichtsystems eine elektrisch leiffähige Oxidschicht ist.

5. Wärmeschutzfolie nach Anspruch 1 und 2, **dadurch gekennzeichnet**, daß das Wechselschichtsystem aus dielektrischen oder elektrisch leiffähigen Oxidschichten und Metallschichten aufgebaut ist, und daß die erste auf der Kunststoffolie aufgebrachte Schicht und die letzte Schicht des Wechselschichtsystems eine dielektrische bzw. elektrisch leiffähige Oxidschicht ist.

6. Wärmeschutzfolie nach Anspruch 1 und 2, **dadurch gekennzeichnet**, daß das Wechselschichtsystem aus transparenten dielektrischen oder elektrisch leiffähigen Oxidschichten und einem jeweils zwischen diesen befindlichen Dreischichtsystem aufgebaut ist, daß das Dreischichtsystem aus zwei Nitridschichten und einer dazwischen befindlichen Metallschicht besteht.

7. Wärmeschutzfolie nach Anspruch 6, **dadurch gekennzeichnet**, daß das Dreischichtsystem aus zwei Oxinitridschichten und einer dazwischen befindlichen Nitridschicht aufgebaut ist.

8. Wärmeschutzfolie nach Anspruch 1 bis 7, **dadurch gekennzeichnet**, daß die dielektrischen Oxidschichten aus Titanoxid, Zirkoniumoxid, Hafniumoxid, Zinnoxid, Zinkoxid, Tantaloxid, Bleioxid oder Kombinationen von diesen bestehen.

9. Wärmeschutzfolie nach Anspruch 1 bis 7, **dadurch gekennzeichnet**, daß die elektrisch leiffähigen Oxidschichten aus Indium-Zinn-Oxid oder Zinkoxid bestehen.

10. Wärmeschutzfolie nach Anspruch 1 bis 7, **dadurch gekennzeichnet**, daß die Nitridschichten aus Titannitrid, Zirkoniumnitrid oder Hafniumnitrid bestehen.

11. Wärmeschutzfolie nach Anspruch 1, 2, 5 bis 7, **dadurch gekennzeichnet**, daß die Metallschichten aus Platin, Titan, Zirkonium, Chrom, Nickel, aus deren Legierungen oder aus rostfreiem Stahl bestehen.

12. Wärmeschutzfolie nach mindestens einem der Ansprüche 1 bis 11, **dadurch gekennzeichnet**, daß die Abriebschutzschicht aus den Oxiden von Aluminium, Zirkonium, Titan oder deren Legierungen besteht.

13. Verfahren zur Herstellung einer transparenten Wärmeschutzfolie gemäß Anspruch 1, indem auf die hochtransparente Kunststoffolie das Wechselschichtsystem und darauf die Abriebschutzschicht in einem Vakuum-Beschichtungsprozeß aufgebracht werden, **dadurch gekennzeichnet**, daß die Metall-, Oxid-, Nitrid- undloder Oxinitridschichten des Wechselschichtsystems auf die Kunststoffolie in wechselnder Folge durch unipolares oder bipolares Pulsmagnetronsputtern aufgebracht werden, und daß das Oxid für die Abriebschutzschicht durch plasma- und/oder ionengestütztes Hochratebedampfen aufgebracht wird.

14. Verfahren nach Anspruch 13, **dadurch gekennzeichnet**, daß die Oxid-, Nitrid- und Oxinitridschichten des Wechselschichtsystems durch reaktives bipolares Pulsmagnetronsputtern mit Dual-Magnetrons aufgebracht werden.

15. Verfahren nach Anspruchen 13 und 14, **dadurch gekennzeichnet**, daß die Abriebschutzschicht aus Oxiden von Zirkonium, Titan oder deren Legierungen durch plasmagestütztes reaktives Elektronenstrahlverdampfen von Zirkonium, Titan oder deren Legierungen unter Verwendung einer Hohlkatoden- oder diffusen Bogenentladung aufgebracht wird.

16. Verfahren nach Anspruch 13 bis 15, **dadurch gekennzeichnet**, daß die Abriebschutzschicht aus Aluminiumoxid durch plasmagestütztes reaktives Verdampfen von Aluminium aus Schiffchenverdampfern aufgebracht wird, und daß das erforderliche intensive Plasma durch Hohlkatodenbogen- oder gepulste Magnetronentladung erzeugt wird.

## Claims

1. A transparent heat protection film for exterior use, consisting of a plastics film and a selectively reflecting alternating layer system, on which a wear resistant layer is applied, characterized in that the alternating layer system consists of corrosion resistant metal, oxide, nitride and/or oxy-nitride layers and the wear resistant layer consists of a highly transparent and homogeneous, amorphous oxide layer at least 1 µm thick, preferably 2 to 5 µm thick, with a high packing density and a micro-hardness of at least 4 GPa, preferably from 5 GPa to 10 GPa.

2. A heat protection film according to claim 1, characterized in that the plastics film is a highly transparent polyester film with minimal filler content and maximum surface smoothness.

3. A heat protection film according to claim 1 or 2, characterized in that the alternating layer system is built up alternately from dielectric oxide layers and electrically conductive nitride layers, and in that the first layer applied to the plastics film and the last layer of the alternating layer system are each a dielectric oxide layer.

4. A heat protection film according to claim 1 or 2, characterized in that the alternating layer system is built up from electrically conductive oxide layers and electrically conductive nitride layers, and in that the first layer applied to the plastics film and the last layer of the alternating layer system are each an electrically conductive oxide layer.

5. A heat protection film according to claim 1 or 2, characterized in that the alternating layer system is built up from dielectric or electrically conductive oxide layers and metal layers, and in that the first layer applied to the plastics film and the last layer of the alternating layer system are each a dielectric or electrically conductive oxide layer.

6. A heat protection film according to claim 1 or 2, characterized in that the alternating layer system is built up from transparent dielectric or electrically conductive oxide layers and a three layer system between these in each case, and in that the three layer system consists of two nitride layers and a metal layer therebetween.

7. A heat protection film according to claim 6, characterized in that the three layer system is built from two oxy-nitride layers and a nitride layer therebetween.

8. A heat protection film according to any of claims 1 to 7, characterized in that the dielectric oxide layers consist of titanium oxide, zirconium oxide, hafnium oxide, tin oxide, zinc oxide, tantalum oxide or combinations thereof.

9. A heat protection film according to any of claims 1 to 7, characterized in that the electrically conductive oxide layers consist of indium-tin oxide or zinc oxide.

10. A heat protection film according to any of claims 1 to 7, characterized in that the nitride layers consist of titanium nitride, zirconium nitride or hafnium nitride.

11. A heat protection film according to any of claims 1, 2, 5 to 7, characterized in that the metal layers consist or platinum, titanium, zirconium, chromium, nickel, their alloys or stainless steel.

12. A heat protection film according to at least one of claims 1 to 11, characterized in that the wear resistant layer consists of the oxides of aluminium, zirconium, titanium or their alloys.

13. A method of making a transparent heat protection film according to claim 1, in which the alternating layer system and the wear resistant layer thereon are deposited in a vacuum coating process, characterized in that the metal, oxide, nitride and/or oxy-nitride layers of the alternating layer system are deposited on the plastics film in alternating sequence by unipolar or bipolar pulsed magnetron sputtering and in that the oxide for the wear resistant layer is deposited by plasma assisted and/or ion assisted high rate vapour deposition.

14. A method according to claim 13, characterized in that the oxide, nitride and oxy-nitride layers of the alternating layer system are deposited by reactive bipolar pulsed magnetron sputtering with a dual magnetron.

15. A method according to claims 13 and 14, characterized in that the wear resistant layer of oxides or zirconium, titanium or their alloys is deposited by plasma assisted reactive electron beam vapour deposition of zirconium, titanium or their alloys, using a hollow cathode or diffuse arc discharge.

16. A method according to any of claims 13 to 15, characterized in that the wear resistant layer of aluminium oxide is deposited by plasma assisted reactive vapour deposition from aluminium from boat vaporisers, and in that the required intensive plasma is created by hollow cathode arc or pulsed magnetron discharge.

## Revendications

1. Feuille transparente de protection thermique, pour application extérieure, constituée d'une feuille en matière synthétique et d'un système à couches alternées, manifestant une caractéristique de réflexion sélective, système sur lequel est appliquée une couche de protection contre l'usure par abrasion,
caractérisée en ce que
le système à couches alternées est constitué de couches métalliques, d'oxydes, de nitrures et/ou d'oxynitrures, présentant une résistance à la corrosion, et la couche de protection contre l'usure par abrasion est constituée d'une couche d'oxyde fortement transparente et homogène, d'une épaisseur d'au moins 1 µm, de préférence de 2 à 5 µm, et d'une couche d'oxyde amorphe homogène, ayant une densité d'empilement élevée et ayant une microdureté d'au moins 4 GPa, de préférence comprise entre 5 GPa et 10 GPa.

2. Couche de protection thermique selon la revendication 1,
caractérisée en ce que
la feuille en matière synthétique est une feuille de polyester fortement transparente ayant une proportion de charge minimale et un lissé de surface maximal.

3. Feuille de protection thermique selon les revendications 1 et 2,
caractérisée en ce que
• le système à couches alternées est constitué alternativement de couches d'oxyde diélectrique et de couches de nitrure conductrices de l'électricité, et
• la première couche appliquée sur la feuille en matière synthétique et la dernière couche du système à couches alternées sont une couche d'oxyde diélectrique.

4. Feuille de protection thermique selon les revendications 1 et 2,
caractérisée en ce que le
système à couches alternées est constitué de couches d'oxyde conductrice de l'électricité et de couches de nitrure conductrice de l'électricité, et en ce que la première couche appliquée sur la feuille de matière synthétique et la dernière couche du système de couches alternées est une couche d'oxyde conductrice de l'électricité.

5. Feuille de protection thermique selon les revendications 1 et 2,
caractérisée en ce que
• le système à couches alternées est constitué de couches d'oxyde diélectriques ou conductrices de l'électricité et de couches métalliques, et
• la première couche appliquée sur la feuille en matière synthétique et la dernière couche du système à couches alternées sont une couche d'oxyde diélectrique ou conductrice de l'électricité.

6. Feuille de protection thermique selon les revendications 1 et 2,
caractérisée en ce que
• le système à couches alternées est constitué de couches d'oxyde diélectriques ou conductrices de l'électricité, transparentes, et d'un système à trois couches se trouvant chaque fois entre celles-ci,
• le système à trois couches est constitué de deux couches de nitrure et d'une couche métallique, placée en position intermédiaire.

7. Feuille de protection thermique selon la revendication 6,
caractérisée en ce que
le système à trois couches est constitué de deux couches d'oxynitrure et d'une couche de nitrure placée en position intermédiaire.

8. Feuille de protection thermique selon les revendications 1 à 7,
caractérisée en ce que
les couches d'oxyde diélectriques sont constituées d'oxyde de titane, d'oxyde de zirconium, d'oxyde d'hafnium, d'oxyde d'étain, d'oxyde de zinc, d'oxyde de tantale, d'oxyde de plomb ou de combinaisons de ces produits.

9. Feuille de protection thermique selon les revendications 1 à 7,
caractérisée en ce que
les couches d'oxyde conductrices de l'électricité sont constituées d'oxyde indium-étain ou d'oxyde de zinc.

10. Feuille de protection thermique selon les revendications 1 à 7,
caractérisée en ce que
les couches de nitrure sont constituées de nitrure de titane, nitrure de zirconium ou nitrure d'hafnium.

11. Feuille de protection thermique selon les revendications 1, 2, 5 à 7,
caractérisée en ce que
les couches métalliques sont constituées de platine, titane, zirconium, chrome, nickel, de leurs alliages ou d'un acier inoxydable.

12. Feuille de protection thermique selon au moins l'une des revendications 1 à 11,
caractérisée en ce que
la couche de protection contre l'usure par abrasion est constituée des oxydes de l'aluminium zirconium, titane ou de leurs alliages.

13. Procédé de fabrication d'une feuille de protection thermique transparente selon la revendication 1, dans lequel, sur la feuille en matière synthétique fortement transparente, est appliqué le système à couche alternée et par-dessus la couche de protection contre l'usure par abrasion, ceci étant fait en un processus de revêtement conduit sous vide,
caractérisé en ce que
• les couches métalliques, d'oxyde, de nitrure et/ou d'oxynitrure du système à couches alternées sont appliquées sur la feuille en matière synthétique en ordre de succession alterné, par une pulvérisation par impulsions au magnétron, unipolaire ou bipolaire, et
• l'oxyde destiné à la couche de protection contre l'usure par abrasion est appliquée par vaporisation à haut débit, au plasma et/ou assisté par des ions.

14. Procédé selon la revendication 13,
caractérisé en ce que
les couches d'oxyde de nitrure et d'oxynitrure du système à couches alternées sont appliquées par pulvérisation par impulsion au magnétron, bipolaire, réactive avec des magnétrons duals.

15. Procédé selon les revendications 13 et 14,
caractérisé en ce que
la couche de protection contre l'usure par abrasion est constituée d'oxydes de zirconium, titane ou leurs alliages, par une vaporisation par rayon d'électrons, réactive, assistée au plasma, de zirconium, titane ou de leurs alliages, avec utilisation d'une décharge en arc, avec cathode creuse ou diffuse.

16. Procédé selon les revendications 13 à 15,
caractérisé en ce que
• la couche de protection contre l'usure par abrasion constituée d'oxyde d'aluminium est appliquée par vaporisation réactive assistée au plasma, d'aluminium, à partir d'évaporateur à cuvette, et
• le plasma intensif nécessaire est généré par décharge en arc avec cathode creuse ou décharge pulsée au magnétron.
